# EUROPÄISCHE PATENTSCHRIFT

(11) **EP 1 090 431 B1**
(45) Veröffentlichungstag und Bekanntmachung des Hinweises auf die Patenterteilung: **15.07.2009**
(21) Anmeldenummer: 00926674.3
(22) Anmeldetag: 08.03.2000
(51) Int. Cl.: H01L 41/047, H01L 41/083

(54) **PIEZOELEKTRISCHER AKTOR**
PIEZOELECTRIC ACTUATOR
ACTIONNEUR PIEZOELECTRIQUE

(30) Priorität: 20.04.1999 DE 19917728
(43) Veröffentlichungstag der Anmeldung: 11.04.2001
(73) Patentinhaber: ROBERT BOSCH GMBH, 70442 Stuttgart (DE)
(72) Erfinder: HEINZ, Rudolf, D-71272 Renningen (DE)
(86) Internationale Anmeldenummer: PCT/DE2000/000732
(87) Internationale Veröffentlichungsnummer: WO 2000/063980

(56) Entgegenhaltungen:
- EP-A- 0 844 678
- DE-A- 19 650 900
- PATENT ABSTRACTS OF JAPAN vol. 1995, no. 11, 26. Dezember 1995 (1995-12-26) & JP 07 226541 A (BROTHER IND LTD), 22. August 1995 (1995-08-22)

## Beschreibung

### Stand der Technik

Die Erfindung betrifft einen piezoelektrischen Aktor, insbesondere zur Betätigung von Steuerventilen oder Einspritzventilen in Kraftfahrzeugen, mit einem Aktorkörper in Form eines vielschichtigen Laminats aus aufeinandergeschichteten Lagen piezoelektrischen Materials und dazwischenliegenden metallischen bzw. elektrisch leitenden, als Elektroden dienenden Schichten, die abwechselnd durch an der Mantelseite in Längsrichtung des Aktorkörpers einander gegenüberliegende metallische Außenelektroden wenigstens in Form flächiger Elektrodenstreifen kontaktiert sind, wobei die Außenelektroden mit elektrischen Anschlußleitern zum Anschluß des piezoelektrischen Aktors an eine elektrische Spannung in Kontakt stehen.

Ein solcher piezoelektrischer Aktor ist z. B. aus der DE 196 50 900 A1 der Robert Bosch GmbH bekannt.

Derartige piezoelektrische Mehrlagenaktoren führen, wenn sie mit einer pulsierenden elektrischen Spannung an ihren Elektrodenschichten beaufschlagt werden, analog pulsierende Hübe unter Änderung des Abstandes zwischen ihren beiden Stirnseiten aus. Bei der zitierten DE 196 50 900 A1 überdecken die die elektrische Spannung zu den Elektrodenschichten übertragenden zu beiden Seiten auf der Mantelseite in Längsrichtung des Aktorkörpers liegenden metallischen Außenelektroden den aktiven Bereich des Aktorkörpers.
Im Betrieb der piezoelektrischen Mehrlagenaktoren können infolge der geringen Zugfestigkeit zwischen den dünnen gestapelten Folien aus Piezokeramik (z. B. BleizirkonatTitanat) und den metallischen bzw. elektrisch leitenden Elektrodenschichten Delaminationen auftreten, die sich als Risse nach außen in die Außenelektroden fortpflanzen und zu Stromunterbrechungen führen können.
Aus der EP 0 844 678 A1 ist eine außenelektrode für einen monolithischen Vielschichtaktor bekannt, dessen Außenlektroden eine elastische wellenförmige Struktur aufweisen oder als Metallschaum ausgebildet sind.

### Aufgabe und Vorteile der Erfindung

Es ist somit Aufgabe der Erfindung, einen gattungsgemäßen piezoelektrischen Mehrlagenaktor so zu ermöglichen, daß stromunterbrechende Risse in den Außenelektroden überbrückt werden und dadurch die Sicherheit der elektrischen Kontaktierung verbessert und die Lebensdauer des piezoelektrischen Aktors verlängert werden können. Diese Aufgabe wird anspruchgemäß gelöst.
Der Kern der Erfindung liegt darin, die unmittelbar am Aktorkörper anliegenden flächigen Elektrodenstreifen zusätzlich mit diese überbrückenden Zusatzelektroden zu verbinden, die über schmale elastische Füße an mehreren Stellen mit den flächigen Elektrodenstreifen in Kontakt stehen.
Bevorzugt haben diese Zusatzelektroden die Form eines Doppelkamms mit einem parallel zu den Elektrodenstreifen liegenden Kammrücken und zwei daran seitlich anschließenden parallelen Zinkenreihen, deren Zinken die elastischen Füße bilden und in Kontakt mit den flächigen Elektrodenstreifen stehen.

Ein Vorteil einer solchen doppelkammartigen Zusatzelektrode ist ihre einfache und sichere Befestigung an dem Elektrodenstreifen infolge der dünnen elastischen Kammzinken. Insbesondere ist zur Kontaktierung eine beliebig dicke Lotschicht nutzbar, die zusätzlich zur Wärmeabfuhr vom Aktorkörper dient.

Die vielen Gestaltungsmöglichkeiten des Doppelkamms gestatten eine optimale Befestigung, eine Herstellungsvereinfachung und eine optimale Kontrolle der Befestigung der doppelkammartigen Zusatzelektrode an den flächigen Elektrodenstreifen.

Der als Zusatzelektrode fungierende Doppelkamm entfaltet nach der Anbringung an den flächigen Elektrodenstreifen am Aktorkörper Eigenstabilität, die durch einen Elastomerzusatz noch gesteigert werden kann. Die beiden Kammreihen bieten über die Lebensdauer des piezoelektrischen Aktors eine hohe Sicherheit gegen evt. auftretende Risse.

Durch den nahezu geschlossenen Kammrücken und wärmeableitendes Elastomer ist eine gute Kühlung des Aktorkörpers möglich.

Ein erfindungsgemäßer piezoelektrischer Aktor läßt sich vorteilhaft für Diesel- oder Benzineinspritzvorrichtungen im Kraftfahrzeug verwenden. Ein solcher piezoelektrischer Aktor kann vorteilhaft das üblicherweise als Verstellorgan bei Einspritzvorrichtungen dienende elektromagnetische System ersetzen, da er schneller schalten kann.

Die obigen und weitere vorteilhaften Merkmale eines erfindungsgemäßen piezoelektrischen Aktors werden aus der nachfolgenden mehrere Ausführungsbeispiele desselben beschreibenden Beschreibung noch deutlicher, wenn diese bezugnehmend auf die Zeichnung gelesen wird.

### Zeichnung

- Figur 1: zeigt schematisch und perspektivisch einen Abschnitt eines mit einer DoppelkammZusatzelektrode ausgerüsteten bevorzugten Ausführungsbeispiels eines erfindungsgemäßen piezoelektrischen Aktors.
- Figur 2: zeigt das bevorzugte Ausführungsbeispiel gemäß Figur 1 in einer Draufsicht.

Die Figuren 3 bis 9 zeigen jeweils verschiedenartige Ausführungsbeispiele einer doppelkammartigen Zusatzelektrode und deren Befestigung an den Elektrodenstreifen.

Die Figuren 10A und 10B zeigen schematisch zwei mögliche Herstellungsverfahren für eine Doppelkamm-Zusatzelektrode mit Hilfe von Drähten;
die Figuren 11A und 11B zeigen schematisch eine alternative Form von als Bürsten ausgeführten Zusatzelektroden gemäß der Erfindung.

### Ausführungsbeispiele

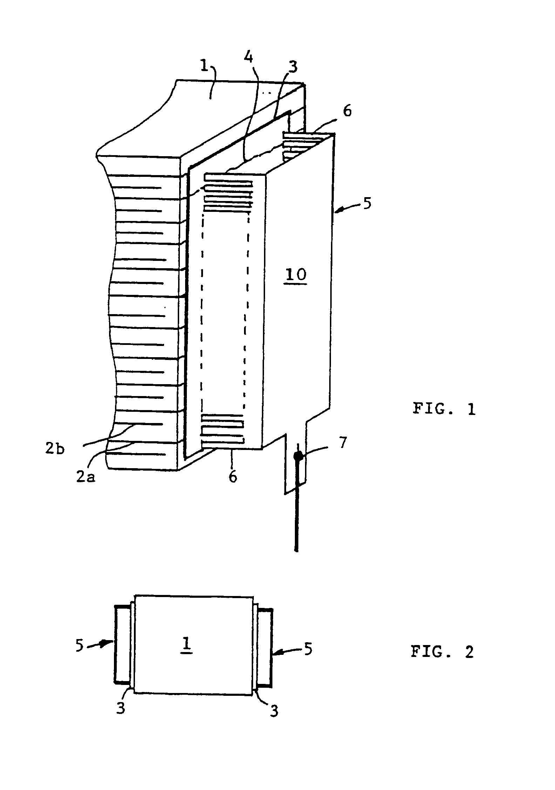

In Figur 1 ist in perspektivischer Darstellung ein erstes Ausführungsbeispiel eines mit einer doppelkammförmigen Zusatzelektrode 5 versehen piezoelektrischen Aktors dargestellt. Der beispielhaft rechteckige Aktorkörper 1 liegt in Form eines vielschichtigen Laminats aus aufeinandergeschichteten Lagen piezoelektrischen Materials und dazwischenliegenden metallischen bzw. elektrisch leitenden, als Elektroden dienenden Schichten 2a und 2b vor. Die Elektrodenschichten 2a und 2b sind abwechselnd durch an der Mantelseite in Längsrichtung des Aktorkörpers 1 einander gegenüberliegende metallische Außenelektroden 3 und 5 kontaktiert und mit elektrischen Anschlußleitern 7, die an der doppelkammförmigen Zusatzelektrode 5 angeschlossen sind, verbunden.

Wie erwähnt, können im Betrieb solcher piezoelektrischer Mehrlagenaktoren infolge der geringen Zugfestigkeit zwischen dem keramischen piezoelektrischen Material und den metallischen Innenelektroden Delaminationen auftreten, die sich nach außen in die flächigen Elektrodenstreifen 3 als Risse fortpflanzen und zu Stromunterbrechungen führen können. Ein solcher Riß 4 ist in Figur 1 beispielhaft angedeutet. Durch die in Form eines Doppelkamms gebildete Zusatzelektrode 5, die aus einem parallel zum flächigen Elektrodenstreifen 3 liegenden Kammrücken 10 und zwei seitlichen, etwa rechtwinklig vom Kammrücken 10 zum zugehörigen flächigen Elektrodenstreifen 3 hin abgebogenen gezinkten Rändern besteht, wobei die schmalen Zinken 6 der Ränder elektrisch mit dem flächigen Elektrodenstreifen 3 in Kontakt stehen, kann eine Stromunterbrechung, wie sie durch den Riß 4 droht, überbrückt werden. Die dünnen Zinken 6 des Doppelkamms bilden eine Vielzahl elastischer Füße, die die durch den Aktorhub bedingte Bewegung des Aktorkörpers 1 elastisch auffangen können und dadurch eine haltbare Kontaktierung der Zusatzelektrode 5 mit dem flächigen Elektrodenstreifen 3 sicherstellen. Die elastischen Zinken 6 können in die flächigen Elektrodenstreifen 3 hineinführen oder an der Oberfläche befestigt, z. B. verlötet, verschweißt, bondiert usw. sein.

Es ist ersichtlich, daß die perspektivische Darstellung der Figur 1 nur eine Seite des rechtwinkligen piezoelektrischen Aktors zeigt.

Die in Figur 2 dargestellte schematische Draufsicht auf einen solchen piezoelektrischen Aktor zeigt, daß zwei doppelkammförmige Zusatzelektroden 5 einander an den Mantelseiten eines Aktorkörpers 1 gegenüberliegen und jeweils mit einem flächigen Elektrodenstreifen 3 in elektrischem Kontakt stehen.

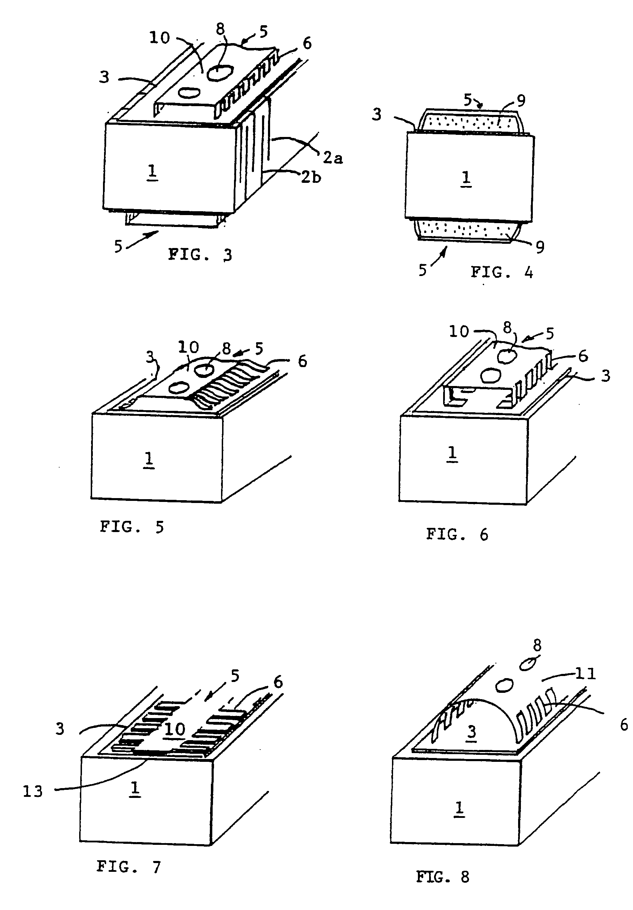

Nachstehend werden verschiedene Formen von erfindungsgemäß als Zusatzelektroden 5 zu verwendenden Doppelkammelektroden anhand der Figuren 3 bis 9 beschrieben. Figur 3 zeigt eine flache Doppelkammelektrode 5 mit ebenem Kammrücken 10 und von diesem um 90° abgewinkelten Zinken 6 und mit Bohrungen oder Löchern 8 auf dem Kammrücken 10.

Durch die Bohrungen 8 kann bei Bedarf Kunststoff, Klebstoff oder ein Elastomer 9 (vergleiche Figur 4) eingegossen werden, um den Doppelkamm 5 zu stabilisieren und/oder die Wärme nach außen abzuleiten.

Figur 5 zeigt ein weiteres Ausführungsbeispiel einer als Zusatzelektrode 5 dienenden Doppelkammelektrode, bei der die Kammzinken 6 nur wenig vom ebenen Kammrücken 10 zu den Elektrodenstreifen 3 abgebogen sind und mit ihrem jeweiligen Endabschnitt mit dem jeweiligen Elektrodenstreifen 3 in Kontakt stehen. Die Befestigung kann erfolgen durch Löten (hart oder weich), Laserschweißen, Punktschweißen, Reibschweißen oder Bondieren. Die Güte der Befestigung der nach außen ragenden Kammzinken 6 ist leicht zu kontrollieren.

Ein weiteres Ausführungsbeispiel einer als Zusatzelektrode 5 geeigneten Doppelkammelektrode ist in Figur 6 dargestellt. Die zu beiden Seiten eines ebenen Kammrückens 10 sitzenden Zinken 6 sind zunächst vom Kammrücken 10 aus um 90° zu dem Elektrodenstreifen 3 hin und dann nach innen parallel zum Elektrodenstreifen 3 abgebogen.

In Figur 7 ist ein weiteres Ausführungsbeispiel einer als Zusatzelektrode 5 geeigneten erfindungsgemäßen Doppelkammelektrode dargestellt, bei der der Kammrücken 10 und die Zinken 6 etwa in einer Ebene liegen.. Zum Schutz gegen völliges Anlöten (sofern Löten verwendet wird) ist in der Mitte unterhalb des Kammrückens 10 ein Lötstopplack 13 aufgebracht. Wenn kein Lötvorgang verwendet wird, kann ein als Elastomerschicht ausgebildeter Abstandshalter 13 den notwendigen Abstand zwischen dem flächigen Elektrodenstreifen 3 und dem Kammrücken 10 halten. Eine PTFE-Schicht 13 oder eine Schicht aus ähnlichem Material kann ferner als Verschleißschutz oder Dämpfungsschicht dienen.

Figur 8 zeigt ein weiteres mögliches Ausführungsbeispiel einer als Zusatzelektrode 5 geeigneten erfindungsgemäßen Doppelkammelektrode, die eine halbrunde oder ovale Querschnittsform mit abgerundetem Kammrücken 11 hat.

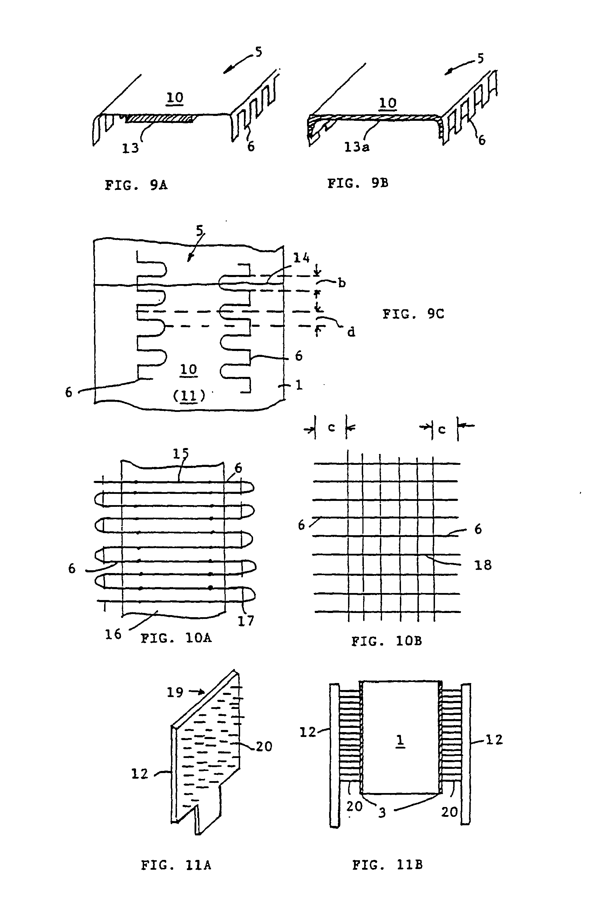

Die Figuren 9A, 9B und 9C zeigen ein weiteres Ausführungsbeispiel einer als Zusatzelektrode 5 für einen piezoelektrischen Aktor gemäß der Erfindung geeigneten erfindungsgemäßen Doppelkammelektrode, die ähnlich geformt ist wie in Figur 6 und zu beiden Seiten des ebenen Kammrückens 10 Zinken 6 hat, die gegenüber dem Kammrücken 10 um etwa 90° abgebogen sind.

Figur 9A zeigt den Abstandshalter oder einen Lötstopplack 13.

Figur 9B zeigt, daß statt eines Abstandshalters oder eines Lötstopplackes 13 auch eine um die Ecke bis nahe zum Ende der Kammzinken 6 gehende Elastomer- oder Kunststoffplatte 13a verwendet werden kann.

Der in Figur 9C gezeigte Grundriß einer als Zusatzelektrode 5 geeigneten Doppelkammelektrode beliebiger Querschnittsform (rechtwinklige oder auch runde bzw. ovale Form wie in Figur 8) zeigt, daß die als elastische Füße dienenden Kammzinken 6 zu beiden Seiten des Kammrückens 10 oder 11 gegeneinander um ein halbes Abstandsintervall d der Zinken 6 in Längsrichtung des Doppelkamms versetzt sind. Ein im Aktorkörper 1 auftretender Riß 14 geht meistens gerade (d. h. unter einem Winkel von 90° zur Außenkante des Aktorkörpers 1) durch die flachen Elektrodenstreifen 3 der Außenelektroden. Durch die Versetzung der Kammzinken 6 um das halbe Abstandsintervall d wird ein Riß nur einen Zinken stören und der gegenüberliegende, versetzte Zinken bleibt völlig fixiert. Das Abstandsintervall 2d und die Zinkenlücken b können den kleinsten möglichen Rissfolgeabständen so angepasst werden, damit kein Riss in zwei gegenüberliegende Füße 6 läuft.

Die Herstellung eines der bislang beschriebenen als Zusatzelektrode 5 geeigneten Doppelkamms kann z. B. durch Ausstanzen einer passenden Doppelkammform aus einem Metallblech geeigneten Materials und gegebenenfalls gleichzeitiges Abbiegen der beiden Zinkenreihen ausgeführt werden. Alternativ kann eine sehr feine Doppelkammstruktur auch durch Laserschneiden aus einem Blech geeigneten Materials hergestellt werden.

Die Figuren 10A und 10B zeigen weitere Beispiele einfacher Herstellungsverfahren für einen als Zusatzelektrode 5 geeigneten Doppelkamm. Dazu wird gemäß Figur 10A ein Draht 15 auf ein Blechband 16 bondiert, geschweißt oder gelötet und die Enden 17 des Drahtes abgeschnitten. Auf diese Weise entsteht ein als Zusatzelektrode für einen erfindungsgemäßen piezoelektrischen Aktor geeigneter Doppelkamm mit sehr schmalen Zinken 6.

Gemäß Figur 10B wird alternativ ein als Zusatzelektrode 5 für einen erfindungsgemäßen piezoelektrischen Aktor geeigneter Doppelkamm aus einem metallischen Sieb hergestellt. Dazu müssen dessen metallische Querfäden 18 auf der Seite um eine genügend große Strecke c herausstehen, so daß eine Doppelkammstruktur entsteht.

In der bisherigen Beschreibung wurden für die Zusatzelektrode 5 verschiedenartige Doppelkammelektroden beschrieben. Gemäß Figur 11A kann jedoch auch eine bürstenartige Struktur 19 als alternative Zusatzelektrode 5 dienen, welche von einem flachen metallischen Bürstenrücken 12 etwa senkrecht abstehende elastische Metallborsten 20 hat, deren Enden gemäß Figur 11B mit den Elektrodenstreifen 3 kontaktiert sind.

Bei allen oben beschriebenen Ausführungsbeispielen können die Kammzinken oder Borsten eines als Zusatzelektrode 5 dienenden Doppelkamms oder einer bürstenartigen Struktur gemäß Figur 11 an den Elektrodenstreifen 3 hart oder weich angelötet oder durch Laserschweißen oder Punktschweißen, Reibschweißen oder Bondieren verbunden werden. Weiterhin ist ein Ankleben mit elektrisch leitfähigem Kleber möglich. Beim Löt-, Schweiß- oder Bondiervorgang läßt sich die Güte der Verbindung zur Elektrode 3 der vom Kammrücken oder Bürstenrücken abstehenden Zinken oder Borsten leicht kontrollieren.

Damit ist eine einfache und sichere Befestigung der Zusatzelektrode 5 an den flachen Elektrodenstreifen 3 aufgrund der dünnen Zinken oder Borsten möglich. Eine beliebig dicke Lötschicht ist nutzbar. Die verschiedenen beschriebenen Ausführungsmöglichkeiten der Kammzinken bzw. Borsten ermöglichen eine optimale Befestigung, eine kostengünstige Herstellung und eine sichere Kontrolle der Befestigung der Zinken bzw. Borsten an den Elektrodenstreifen 3. Die meist größere Wärmedehnung der Zusatzelektrode 5 gegenüber der Keramik ergibt wegen der kleinen Kontakte zwischen der Zusatzelektrode 5 und dem Elektrodenstreifen 3 nur geringe Schubspannungen und damit höhere Ausfallsicherheit.

Die Zusatzelektrode bekommt durch ihre Form, nachdem sie an den flächigen Elektrodenstreifen angebracht ist, oder durch eine zusätzlich eingebrachte Elastomerschicht eine ausreichende Eigenstabilität. Ein Doppelkamm läßt sich auf vielerlei Weise kostengünstig herstellen. Da vorschlagsgemäß eine als Zusatzelektrode geeignete Kammelektrode zwei Zinkenreihen hat, ist eine hohe Sicherheit gegeben, daß möglichst viele Zinken der Kammelektrode mit dem zugehörigen Elektrodenstreifen elektrisch leitend verbunden sind. Durch den, abgesehen von den Öffnungen 8, nahezu geschlossenen metallischen Kammrücken des Doppelkamms und ein gegebenenfalls eingebrachtes wärmeleitendes Elastomer ist eine gute Möglichkeit der Wärmeableitung des Aktorkörpers erreichbar.

## Patentansprüche

1. Piezoelektrischer Aktor, insbesondere zur Betätigung von Steuerventilen oder Einspritzventilen in Kraftfahrzeugen, mit einem Aktorkörper (1) in Form eines vielschichtigen Laminats aus aufeinandergeschichteten Lagen piezoelektrischen Materials und dazwischenliegenden metallischen bzw. elektrisch leitenden, als Elektroden dienenden Schichten (2a, 2b), die abwechselnd durch an der Mantelseite in Längsrichtung des Aktorkörpers (1) einander gegenüberliegende metallische Außenelektroden (3, 5) wenigstens in Form flächiger Elektrodenstreifen (3) kontaktiert sind, wobei die Außenelektroden (3, 5) mit elektrischen Anschlußleitern (7) zum Anschluß des piezoelektrischen Aktors an eine elektrische Spannung in Kontakt stehen, wobei die Außenelektroden (3, 5) außerdem Zusatzelektroden (5) aufweisen, die über schmale elastische Füße (6) an mehreren Stellen mit den flächigen Elektrodenstreifen (3) in Kontakt stehen, **dadurch gekennzeichnet, daß** die Zusatzelektroden parallel zu den Elektrodenstreifen (3) liegende Doppelkämme bilden, die einen Kammrücken (10, 11) und daran anschließende zwei parallele seitliche Zinkenreihen aufweisen, deren Zinken (6) die elastischen Füße sind.

2. Piezoelektrischer Aktor nach Anspruch 1, **dadurch gekennzeichnet, daß** die Zusatzelektroden (5) parallel zu den Elektrodenstreifen (3) liegende kammartige Streifen mit äquidistanten, die elastischen Füße bildenden Zinken (6) bilden.

3. Piezoelektrischer Aktor nach Anspruch 1 oder 2, **dadurch gekennzeichnet, daß** die Zinken (6) vom Kammrücken (10) etwa rechtwinklig zu den Elektrodenstreifen (3) abgewinkelt sind und nur die Enden der Zinken (6) mit dem jeweiligen Elektrodenstreifen (3) in Kontakt stehen.

4. Piezoelektrischer Aktor nach einem der vorhergehenden Ansprüche, **dadurch gekennzeichnet, daß** die Zinken (6) vom Kammrücken (10) im flachen Winkel zu den Elektrodenstreifen (3) abgewinkelt sind und die Endabschnitte der Zinken (6) mit dem jeweiligen Elektrodenstreifen (3) in Kontakt stehen.

5. Piezoelektrischer Aktor nach einem der vorhergehenden Ansprüche, **dadurch gekennzeichnet, daß** der Kammrücken (11) mit den beidseitigen Zinken (6) eine etwa halbkreisförmige oder ovale Querschnittskontur hat.

6. Piezoelektrischer Aktor nach einem der vorhergehenden Ansprüche, **dadurch gekennzeichnet, daß** der Kammrücken (14) mit den beidseitigen Zinken (6) etwa in einer Ebene liegt.

7. Piezoelektrischer Aktor nach einem der vorhergehenden Ansprüche, **dadurch gekennzeichnet, daß** zwischen dem Kammrücken (10, 11) und dem zugeordneten Elektrodenstreifen (3) ein Abstandshalter (13) liegt.

8. Piezoelektrischer Aktor nach Anspruch 7, **dadurch gekennzeichnet, daß** der Abstandshalter (13) als Elastomerunterlage oder als Lötstopplack ausgebildet ist.

9. Piezoelektrischer Aktor nach einem der vorhergehenden Ansprüche, **dadurch gekennzeichnet, daß** die äquidistanten Zinken (6) auf beiden Seiten des Kammrückens (10, 11) gegeneinander um ein halbes Abstandsintervall der Zinken (6) in Längsrichtung des Doppelkamms versetzt sind.

10. Piezoelektrischer Aktor, insbesondere zur Betätigung von Steuerventilen oder Einspritzventilen in Kraftfahrzeugen, mit einem Aktorkörper (1) in Form eines vielschichtigen Laminats aus aufeinandergeschichteten Lagen piezoelektrischen Materials und dazwischenliegenden metallischen bzw. elektrisch leitenden, als Elektroden dienenden Schichten (2a, 2b), die abwechselnd durch an der Mantelseite in Längsrichtung des Aktorkörpers (1) einander gegenüberliegende metallische Außenelektroden (3, 5) wenigstens in Form flächiger Elektrodenstreifen (3) kontaktiert sind, wobei die Außenelektroden (3, 5) mit elektrischen Anschlußleitern (7) zum Anschluß des piezoelektrischen Aktors an eine elektrische Spannung in Kontakt stehen, wobei die Außenelektroden (3, 5) außerdem Zusatzelektroden (5) aufweisen, die über schmale elastische Füße (6) an mehreren Stellen mit den flächigen Elektrodenstreifen (3) in Kontakt stehen, **dadurch gekennzeichnet, daß** die Zusatzelektrode (5) eine parallel zu dem jeweiligen Elektrodenstreifen (3) liegende Elektrodenbürste (19) bildet, deren Borsten (20) die mit den Elektrodenstreifen (3) kontaktierten elastischen Füße bilden, und dass die Borsten (20) von einem flachen Bürstenrücken (12) etwa senkrecht abstehen.

11. Piezoelektrischer Aktor nach einem der vorhergehenden Ansprüche, **dadurch gekennzeichnet, daß** der Kamm- oder Bürstenrücken (10, 11, 12) mehrere Löcher (8) aufweist.

12. Piezoelektrischer Aktor nach einem der vorangehenden Ansprüche, **dadurch gekennzeichnet, daß** die Anschlußleiter (7) jeweils an den Zusatzelektroden (5) angeschlossen sind.

13. Piezoelektrischer Aktor nach einem der vorangehenden Ansprüche, **dadurch gekennzeichnet, daß** die elastischen Füße bzw. Zinken (6) oder Borsten (20) der Zusatzelektroden (5) mit den Elektrodenstreifen (8) durch eine Lotschicht verlötet sind.

14. Piezoelektrischer Aktor nach einem der Ansprüche 1 bis 12, **dadurch gekennzeichnet, daß** die elastischen Füße bzw. Zinken (6) oder Borsten (20) der Zusatzelektroden durch eine elektrisch leitende Klebeschicht mit den Elektrodenstreifen (3) verbunden sind.

15. Piezoelektrischer Aktor nach einem der Ansprüche 1 bis 12, **dadurch gekennzeichnet, daß** die elastischen Füße bzw. Zinken (6) oder Borsten (20) der Zusatzelektroden (5) durch Laserschweißpunkte mit den Elektrodenstreifen (3) verbunden sind.

16. Piezoelektrischer Aktor nach einem der Ansprüche 1 bis 12, **dadurch gekennzeichnet, daß** die elastischen Füße bzw. Zinken (6) oder Borsten (20) der Zusatzelektroden (5) mit den Elektrodenstreifen (3) bondiert sind.

## Claims

1. Piezoelectric actuator, in particular for the actuation of control valves or injection valves in motor vehicles, with an actuator body (1) in the form of a multilayered laminate comprising layers of piezoelectric material laid one on top of the other and metallic or electrically conducting layers (2a, 2b) lying in between, serving as electrodes and contacted alternately by metallic outer electrodes (3, 5) lying peripherally opposite one another in the longitudinal direction of the actuator body (1), at least in the form of sheet-like electrode strips (3), the outer electrodes (3, 5) being in contact with electrical terminal conductors (7) for the connection of the piezoelectric actuator to an electrical voltage, and the outer electrodes (3, 5) also having additional electrodes (5), which are in contact with the sheet-like electrode strips (3) at a number of points by means of narrow flexible feet (6), **characterized in that** the additional electrodes form interdigitated combs lying parallel to the electrode strips (3) and having a comb back (10, 11) and two parallel lateral rows of prongs adjoining thereto, the prongs (6) of which are the flexible feet.

2. Piezoelectric actuator according to Claim 1,
**characterized in that** the additional electrodes (5) form comb-like strips lying parallel to the electrode strips (3) and having equidistant prongs (6), forming the flexible feet.

3. Piezoelectric actuator according to Claim 1 or 2, **characterized in that** the prongs (6) are angled away from the comb back (10) approximately at right angles to the electrode strips (3) and only the ends of the prongs (6) are in contact with the respective electrode strip (3).

4. Piezoelectric actuator according to one of the preceding claims, **characterized in that** the prongs (6) are angled away from the comb back (10) at a shallow angle in relation to the electrode strips (3) and the end portions of the prongs (6) are in contact with the respective electrode strip (3).

5. Piezoelectric actuator according to one of the preceding claims, **characterized in that** the comb back (11) with the prongs (6) on both sides has an approximately semicircular or oval cross-sectional contour.

6. Piezoelectric actuator according to one of the preceding claims, **characterized in that** the comb back (14) lies approximately in a plane with the prongs (6) on both sides.

7. Piezoelectric actuator according to one of the preceding claims, **characterized in that** a spacer (13) lies between the comb back (10, 11) and the assigned electrode strip (3).

8. Piezoelectric actuator according to Claim 7,
**characterized in that** the spacer (13) is formed as an elastomer underlay or as a solder resist.

9. Piezoelectric actuator according to one of the preceding claims, **characterized in that** the equidistant prongs (6) on both sides of the comb back (10, 11) are offset with respect to one another in the longitudinal direction of the interdigitated comb by half a spacing interval of the prongs (6).

10. Piezoelectric actuator, in particular for the actuation of control valves or injection valves in motor vehicles, with an actuator body (1) in the form of a multilayered laminate comprising layers of piezoelectric material laid one on top of the other and metallic or electrically conducting layers (2a, 2b) lying in between, serving as electrodes and contacted alternately by metallic outer electrodes (3, 5) lying peripherally opposite one another in the longitudinal direction of the actuator body (1), at least in the form of sheet-like electrode strips (3), the outer electrodes (3, 5) being in contact with electrical terminal conductors (7) for the connection of the piezoelectric actuator to an electrical voltage, and the outer electrodes (3, 5) also having additional electrodes (5), which are in contact with the sheet-like electrode strips (3) at a number of points by means of narrow flexible feet (6), **characterized in that** the additional electrode (5) forms an electrode brush (19) lying parallel to the respective electrode strip (3), the bristles (20) of which brush form the flexible feet used to form contact with the electrode strips (3), and **in that** the bristles (20) protrude approximately perpendicularly from a flat brush back (12).

11. Piezoelectric actuator according to one of the preceding claims, **characterized in that** the comb or brush back (10, 11, 12) has a number of holes (8).

12. Piezoelectric actuator according to one of the preceding claims, **characterized in that** the terminal conductors (7) are respectively connected to the additional electrodes (5).

13. Piezoelectric actuator according to one of the preceding claims, **characterized in that** the flexible feet or prongs (6) or bristles (20) of the additional electrodes (5) are soldered to the electrode strips (8) by a layer of solder.

14. Piezoelectric actuator according to one of Claims 1 to 12, **characterized in that** the flexible feet or prongs (6) or bristles (20) of the additional electrodes are connected to the electrode strips (3) by a layer of electrically conducting adhesive.

15. Piezoelectric actuator according to one of Claims 1 to 12, **characterized in that** the flexible feet or prongs (6) or bristles (20) of the additional electrodes (5) are connected to the electrode strips (3) by laser spot welds.

16. Piezoelectric actuator according to one of Claims 1 to 12, **characterized in that** the flexible feet or prongs (6) or bristles (20) of the additional electrodes (5) are bonded to the electrode strips (3).

## Revendications

1. Actionneur piézoélectrique, notamment pour actionner des soupapes de distribution ou des injecteurs dans des véhicules automobiles, comprenant un corps d'actionneur (1) sous la forme d'un stratifié à plusieurs couches constitué de couches empilées les unes sur les autres de matériaux piézoélectriques et de couches (2a, 2b) métalliques ou électriquement conductrices disposées entre celles-ci et faisant office d'électrodes, lesquelles sont alternativement en contact par le biais d'électrodes extérieures métalliques (3, 5) au moins sous la forme de bandes d'électrode plates (3) opposées les unes aux autres sur le côté de l'enveloppe dans le sens longitudinal du corps d'actionneur (1), les électrodes extérieures (3, 5) étant en contact avec des conducteurs de raccordement électriques (7) pour raccorder l'actionneur piézoélectrique à une tension électrique, les électrodes extérieures (3, 5) présentant en plus des électrodes supplémentaires (5) qui sont en contact en plusieurs endroits avec les bandes d'électrode plates (3) par le biais de pieds souples étroits (6), **caractérisé en ce que** les électrodes supplémentaires forment des doubles peignes disposés parallèlement aux bandes d'électrode (3), lesquels présentent un dos de peigne (10, 11) et deux rangées de dents latérales parallèles rattachées à celui-ci, dont les dents sont les pieds souples (6).

2. Actionneur piézoélectrique selon la revendication 1, **caractérisé en ce que** les électrodes supplémentaires (5) forment des bandes de type peigne disposées parallèlement aux bandes d'électrode (3) et munies de dents (6) équidistantes qui forment les pieds souples.

3. Actionneur piézoélectrique selon la revendication 1 ou 2, **caractérisé en ce que** les dents (6) partant du dos de peigne (10) sont coudées approximativement en angle droit par rapport aux bandes d'électrode (3) et seules les extrémités des dents (6) sont en contact avec les bandes d'électrode (3) respectives.

4. Actionneur piézoélectrique selon l'une des revendications précédentes, **caractérisé en ce que** les dents (6) partant du dos de peigne (10) sont coudées approximativement selon un angle plan par rapport aux bandes d'électrode (3) et les sections d'extrémité des dents (6) sont en contact avec les bandes d'électrode (3) respectives.

5. Actionneur piézoélectrique selon l'une des revendications précédentes, **caractérisé en ce que** le dos de peigne (11) muni des dents (6) des deux côtés présente un profil de section transversale environ en demi-cercle ou ovale.

6. Actionneur piézoélectrique selon l'une des revendications précédentes, **caractérisé en ce que** le dos de peigne (14) se trouve approximativement dans un même plan avec les dents (6).

7. Actionneur piézoélectrique selon l'une des revendications précédentes, **caractérisé en ce qu'**il existe un élément d'écartement (13) entre le dos de peigne (10, 11) et les bandes d'électrode (3) associées.

8. Actionneur piézoélectrique selon la revendication 7, **caractérisé en ce que** l'élément d'écartement (13) est réalisé sous la forme d'un support en élastomère ou d'un vernis barrière à brasure.

9. Actionneur piézoélectrique selon l'une des revendications précédentes, **caractérisé en ce que** les dents (6) équidistantes des deux côtés du dos de peigne (10, 11) sont décalées les unes par rapport aux autres d'un demi-intervalle d'écart entre les dents (6) dans le sens longitudinal du double peigne.

10. Actionneur piézoélectrique, notamment pour actionner des soupapes de distribution ou des injecteurs dans des véhicules automobiles, comprenant un corps d'actionneur (1) sous la forme d'un stratifié à plusieurs couches constitué de couches empilées les unes sur les autres de matériaux piézoélectriques et de couches (2a, 2b) métalliques ou électriquement conductrices disposées entre celles-ci et faisant office d'électrodes, lesquelles sont alternativement en contact par le biais d'électrodes extérieures métalliques (3, 5) au moins sous la forme de bandes d'électrode plates (3) opposées les unes aux autres sur le côté de l'enveloppe dans le sens longitudinal du corps d'actionneur (1), les électrodes extérieures (3, 5) étant en contact avec des conducteurs de raccordement électriques (7) pour raccorder l'actionneur piézoélectrique à une tension électrique, les électrodes extérieures (3, 5) présentant en plus des électrodes supplémentaires (5) qui sont en contact en plusieurs endroits avec les bandes d'électrode plates (3) par le biais de pieds souples étroits (6), **caractérisé en ce que** l'électrode supplémentaire (5) forme un balai d'électrodes (19) disposé parallèlement aux bandes d'électrode (3) respectives, dont les soies (20) forment les pieds souples en contact avec les bandes d'électrode (3) et que les soies (20) sortent approximativement perpendiculairement d'un dos de brosse plat (12).

11. Actionneur piézoélectrique selon l'une des revendications précédentes, **caractérisé en ce que** le dos de peigne ou de brosse (10, 11, 12) présente plusieurs trous (8).

12. Actionneur piézoélectrique selon l'une des revendications précédentes, **caractérisé en ce que** les conducteurs de raccordement (7) sont respectivement raccordés aux électrodes supplémentaires (5).

13. Actionneur piézoélectrique selon l'une des revendications précédentes, **caractérisé en ce que** les pieds souples ou les dents (6) ou les soies (20) des électrodes supplémentaires (5) sont brasés aux bandes d'électrode (3) par une couche de brasure.

14. Actionneur piézoélectrique selon l'une des revendications 1 à 12, **caractérisé en ce que** les pieds souples ou les dents (6) ou les soies (20) des électrodes supplémentaires sont reliés aux bandes d'électrode (3) par une couche de colle électriquement conductrice.

15. Actionneur piézoélectrique selon l'une des revendications 1 à 12, **caractérisé en ce que** les pieds souples ou les dents (6) ou les soies (20) des électrodes supplémentaires (5) sont reliés aux bandes d'électrode (3) par des points de soudage au laser.

16. Actionneur piézoélectrique selon l'une des revendications 1 à 12, **caractérisé en ce que** les pieds souples ou les dents (6) ou les soies (20) des électrodes supplémentaires (5) sont fixés aux bandes d'électrode (3) par bonding.
